**Europäisches Patentamt**

**European Patent Office**

**Office européen des brevets**

(19)

(11) Publication number: **0 164 951**
**B1**

(12) **EUROPEAN PATENT SPECIFICATION**

(45) Date of publication of patent specification: **01.08.90**

(51) Int. Cl.⁵: **G 01 N 24/08**

(21) Application number: **85303745.5**

(22) Date of filing: **29.05.85**

(54) Improved methods for two dimensional nuclear magnetic resonance imaging.

(30) Priority: **04.06.84 US 617163**

(43) Date of publication of application:
**18.12.85 Bulletin 85/51**

(45) Publication of the grant of the patent:
**01.08.90 Bulletin 90/31**

(84) Designated Contracting States:
**AT BE CH DE FR GB IT LI LU NL SE**

(56) References cited:
**EP-A-0 021 535**
**EP-A-0 024 640**
**EP-A-0 076 054**
**FR-A-2 533 031**

**MEDICAL PHYSICS, vol. 10, no. 5,
September/October 1983, pages 610-621,
American Association of Phys. Med., New York,
US; D.B. TWIEG: "The k-trajectory of the NMR
imaging process with applications in analysis
and synthesis of imaging methods"**

(73) Proprietor: **INDIANA UNIVERSITY
FOUNDATION
Showalter House P.O. Box 500
Bloomington Indiana 47402 (US)**

(72) Inventor: **Kaplan, Jerome Ira
4417 North Pennsylvania
Indianapolis Indiana 4205 (US)**

(74) Representative: **Newstead, Michael John et al
Haseltine Lake & Co. 28 Southampton Buildings
Chancery Lane
London, WC2A 1AT (GB)**

Courier Press, Leamington Spa, England.

**Description**

The present invention relates to methods for obtaining improved nuclear magnetic resonance (NMR) images from those disclosed in the art. The use of time varying magnetic field gradients such that the frequency history of the spins in every element of a two-dimensional array is distinguishable from that of every other element in that array have been described in the art. However, the methods described in the art do not, in fact, provide tractable approaches for obtaining NMR images from the use of such time varying magnetic field gradients.

A number of NMR techniques for spacial mapping of points, lines and planes in a sample of matter are known in the art. The particular procedure whereby the use of time varying magnetic field gradients such that the frequency history of each element in an array is distinguishable from that of every other element in that array has been suggested in the patent to Likes (U.S. Pat. 4,307,343).

However, the methods described by Likes suffer from a number of shortcomings. First, Likes fails to recognize the necessity of an appropriate weighting function which is required for image reconstruction, and is necessitated by the use of gradient magnetic fields whose trajectories in phase space do not sample equal areas of that space during equal time intervals. Additionally, Likes fails to provide a method for varying the gradient magnetic fields to map equal areas of phase space in equal time intervals and thus avoid the necessity of an appropriate weighting function.

The present invention seeks to improve the methods disclosed in the prior art.

According to a first aspect of the present invention, there is provided a method for nuclear magnetic resonance imaging comprising sensitizing a region of an object in a static magnetic field wherein the magnetization of the spins are transverse to the static field, applying to the sensitized region of the object a time varying magnetic field gradient which samples unequal areas of phase space in equal time intervals, detecting radiated electromagnetic energy from the sensitized region, and reconstructing spin information for each element within the region from the received radiated electromagnetic energy signals, characterised by the step of:

weighting the detected radiated electromagnetic energy signals to compensate for the use of time varying magnetic field gradients that do not sample equal areas of phase space in equal time intervals.

According to a second aspect of the present invention, there is provided a method for nuclear magnetic resonance imaging comprising sensitizing a region of an object in a static magnetic field wherein the magnetization of the spins are transverse to the static field, spatially differentiating radiated electromagnetic energy from the sensitized region of the object, detecting the radiated electromagnetic energy from the sensitized region, and reconstructing spin information for each element within the region from the received radiated electromagnetic energy signals, characterised by the step of:

spatially differentiating the radiated electromagnetic energy by applying to the sensitized region a time varying magnetic field gradient which has a trajectory which maps through equal areas $\Delta A_i$ of phase space during equal time intervals, the magnetic field gradient having phases $f_1$ and $f_2$ defined by $f_1 = c\theta\cos\theta$ and $f_2 = c\theta\sin\theta$, and wherein the area $\Delta A_i$ over which the trajectory maps during equal time periods is given by

$$\Delta A_i = 2\pi c^2 \theta_i d\theta_i/dt\Delta t_i$$

wherein $\Delta A_i$ and $\Delta t_i$ are constant, and $\theta = (A+Bt)^{1/2}$, wherein A and B are constants.

The methods of the present invention comprise sensitizing by standard procedures a region of an object in the presence of a static magnetic field. In one embodiment, the region is a two-dimensional slice of the object. Within this slice, the magnetization of the nuclear spins is caused to be rotated at each point transverse to the static field. A time varying magnetic field gradient is then applied to the sensitized two dimensional slice, and electromagnetic energy radiated from the two-dimensional slice is detected. Spin information for each area element within a slice is then reconstructed from the received radiated electromagnetic energy. In one aspect, the improvement is the use of an appropriate weighting function in the reconstruction to weight the received radiated electromagnetic energy signal to compensate for the use of time varying magnetic field gradients that do not sample equal areas of phase space with equal time. In another independent aspect, a uniquely specified class of time varying magnetic field gradient trajectories are defined which map equal area elements of two-dimensional phase space in equal time intervals.

All nuclei with magnetic moments, an example being the hydrogen nucleus, when placed in a static magnetic field, precess (at a frequency $\omega$) about the magnetic field direction. Applying an effective 90° electromagnetic pulse to a nucleus in a magnetic field at a frequency close to the frequency of the angular precession induces a rotation of the magnetization to a direction transverse to the direction of the static magnetic field (the nucleus absorbs energy). The return of the magnetization to equilibrium generates radiation, which radiation may be sampled or detected. In a bulk sample containing many nuclei the time course for such radiation is a function of the environment of the nuclei, via the longitudinal relaxation time $(T_1)$ and the transverse relaxation time $(T_2)$. In general $T_1$ is usually much higher than $T_2$.

In two-dimensional nuclear magnetic imaging the nuclear spin information is determined for individual area elements within a two-dimensional slice of matter. It is critical in two-dimensional imaging that the spin information from one element is distinguishable from the spin information from every other element within the slice. One method, suggested by Likes in U.S. Patent 4,307,343 is to use time varying magnetic field gradients within the sensitized two-dimensional slice so that the frequency history of the spins in each element in the slice is distinguishable from that of every other element. Variations on this general approach are more fully described below.

According to the methods of the present invention, a two-dimensional slice of an object in the presence of a static magnetic field of an NMR spectrometer is sensitized by standard procedures. In the sensitized slice the magnetization of the spins is transverse to the static field. A time varying magnetic field gradient is then applied within the slice so the frequency history of the spins in each element of the two-dimensional slice is distinguishable from that of every other element in the slice. The nuclei in the slice then radiate electromagnetic energy which is sampled, and the sampled electromagnetic energy is converted by reconstruction means to spin information for each element of the two-dimensional slice. In the method according to a first aspect of the present invention the effect of time varying magnetic fields that do not sample equal areas of phase space in equal time is compensated for during the reconstruction phase. In a preferred embodiment of the present invention, sampling is performed at non-uniform time intervals so that each sample represents an equal of phase space. In the methods according to the second aspect of the present invention, a unique class of magnetic field gradients is used, which provides time varying magnetic fields that sample equal areas of phase space during equal time intervals.

Using the method according to the first aspect of the present invention, any gradient magnetic field trajectory which substantially covers two-dimensional phase space may be used to map that space. During image reconstruction, an appropriate weighting function is applied to account for the failure of the gradient field to pass through equal area increments in equal time intervals.

According to other methods of the present invention the reconstruction of the two-dimensional image may be performed without the use of any weighting function.

A general subclass of Archimedian spiral gradient field trajectories has been determined that map equal area elements in equal time intervals.

Examples 1 and 2: One method of the present invention involves the use of an appropriate weighting function to weight the received radiated electromagnetic energy signals to compensate for the non-uniform time varying magnetic field gradients that do not sample equal area increments of phase space with equal time.

A two-dimensional Fourier transform may be defined as follows:

$$F(f_1 f_2) = \iint \rho(x,y) e^{i(f_1 x + f_2 y)} e^{-(t_1 + t_2)/T_2} dx\, dy \tag{1}$$

wherein $\rho(x,y)$ is the spin information in the $(x,y)$ plane; wherein the phases are defined $f_1 = c_1 t_1$, and $f_2 = c_2 t_2$; and wherein the applied gradient field is defined for the x direction $(H_x = c_1 x)$ and for the y direction $(H_y = c_2 y)$. Note for example that $c_1 tx = f_1 x = \int_0^t H_x dt$.

The inverse Fourier transform is defined as:

$$\rho(x,y) = \sum_{f_1} \sum_{f_2} F(f_1, f_2) e^{-i(f_1 x + f_2 y)} e^{(t_1 + t_2)/T_2} \Delta t_1 \, \Delta t_2 \tag{2}$$

wherein the summation is performed over time increments $(\Delta t_1, \Delta t_2)$ in $(f_1, f_2)$ space.

However, $f_1$ and $f_2$ may both be defined as a function of a single time parameter $(t)$ wherein the gradient fields are defined $H_x = c_1 x$ and $H_y = c_2 y \cos t$ with the corresponding phases $f_1 = c_1 t$ and $f_2 = c_2 \sin t$. In order to ensure mapping of the entire slice, $c_2$ is defined to be much larger than $c_1$. This gradient field function does not map through equal areas $\Delta A$ of $(f_1, f_2)$ phase space in equal time intervals, that is, sin t is not linear in t. Thus, an appropriate weighting function $(\Delta A(t))$ must be applied to correctly reconstruct spin information. As a result, the corrected inverted Fourier transform is given by:

$$\rho(x,y) = \Sigma F(f_1, f_2) e^{-i(f_1 x + f_2 y)} e^{t/T_2} \Delta A(t) \tag{2}$$

wherein for the above-defined gradient fields $W(t) = c_1 c_2 \cos t$ and the summation is performed over equal time intervals $\Delta t$, and wherein $W(t)(\Delta t)^2 = \Delta A(t)$.

Alternatively, after the weighting function has been determined, one may map for equal areas in phase space by sampling the radiated electromagnetic energy at unequal time intervals. The unequal time interval is obtained by requiring the area element $\Delta A_i$ to be constant $(\Delta A_i = \Delta A)$:

$$\Delta A = c_1 c_2 \Delta t_i^2 \cos t_i \tag{4}$$

Solving for $\Delta t_i$ one then obtains:

$$\Delta t_i = \left[ \frac{\Delta A}{c_1 c_2 \cos t_i} \right]^{1/2} \tag{5}$$

It should be understood that nearly any gradient field function that substantially covers two dimensional phase space may be substituted for the above functions and may be appropriately weighted on reconstruction. Alternatively, almost any gradient field function that substantially covers two-dimensional phase space may be used to map equal areas in phase by imposing an equal area condition on the sampling time intervals, as shown above for one method.

Examples 3 and 4: A selected class of magnetic field gradient functions may be defined that map equal area elements of phase space in equal time intervals. An example of this selected class is a subset of Archimedian spirals. In general, Archimedian spirals are defined $f_1 = c\theta\cos\theta$ and $f_2 = c\theta\sin\theta$. If $\theta$ is defined as being equal to t, then $f_1 = ct\cos t$ and $f_2 = ct\sin t$. Inversion of the Fourier transform yields

$$\rho(x,y) = \Sigma F)f_1,f_2)e^{-i(f_1x + f_2y)}e^{t/T_2}\Delta A \tag{6}$$

for which the area $\Delta A$ is obtained as

$$\left(2\pi c^2\theta\frac{d\theta}{dt}\ \Delta t\right).$$

For the above choice of $\theta$, $\Delta A = 2\pi c^2 t\Delta t$.

For the first $(2\pi)$ cycle of the above function $\Delta A$ must be separately defined. A good choice is:

$$\Delta A = c^2\left[\frac{\pi^2}{3} + \frac{11\pi t}{6}\right]\Delta t \tag{7}$$

On the other hand, $\theta$ can be defined so that $\Delta A$ is independent of time. This is facilitated by defining

$$\theta = (a + bt)^{1/2} \tag{8}$$

where a and b are constants.

It follows that $\Delta A = \pi c^2 b\Delta t$.

Here, $\Delta A$ is independent of time after the first $2\pi$ cycle. The variation in the first cycle can be compensated for in a method similar to that described above.

The foregoing is intended to illustrate the methods of the present invention and are not intended to limit its scope. As one skilled in the art would recognize, many modifications may be made to the present invention which fall within the scope of the appended claims. Specifically, one would recognize that the two-dimensional methods decribed herein may be readily modified to perform three-dimensional NMR imaging.

## Claims

1. A method for nuclear magnetic resonance imaging comprising sensitizing a region of an object in a static magnetic field wherein the magnetization of the spins are transverse to the static field, applying to the sensitized region of the object a time varying magnetic field gradient which samples unequal areas of phase space in equal time intervals, detecting radiated electromagnetic energy from the sensitized region, and reconstructing spin information for each element within the region from the received radiated electromagnetic energy signals, characterised by the step of:

weighting the detected radiated electromagnetic energy signals to compensate for the use of time varying magnetic field gradients that do not sample equal areas of phase space in equal time intervals.

2. A method, as claimed in claim 1, wherein the region of the object comprises a two-dimensional slice, and the spin information is reconstructed according to the equation:

$$\rho(x,y) = \Sigma F(f_1,f_2)e^{-i(f_1x + f_2y)}e^{(t/T_2)}W(t)\Delta t^2$$

wherein $F(f_1,f_2)$ is the Fourier transform of the detected, radiated electromagnetic energy signals, $f_1$ and $f_2$ are the phase parameters in the x and y directions respectively, $f_1 = c_1t$ and $f_2 = c_2\sin t$, $T_2$ is the transverse relaxation time, and $W(t)$ is the weighting function defined by $W(t) = c_1c_2\cos t$, $c_1$ and $c_2$ being constants.

3. A method as claimed in claim 1 or 2, further characterised by the step of:

sampling the radiated electromagnetic energy at varying time intervals, the varying time intervals being correlated to the nonlinear trajectory of the field gradient such that the radiated electromagnetic energy is sampled at equal area elements of phase space.

4. A method as claimed in claim 3, further characterised by the steps of:

employing a magnetic field gradient which maps an Archimedian spiral trajectory according to the equation $r = c\theta$ and wherein the gradient maps unequal areas $\Delta A$ during equal time periods $\Delta t$ the unequal areas being defined by

$$\Delta A = 2\pi c^2\theta_i d\theta_i/dt\Delta t$$

wherein c is a constant; and

sampling the radiated electromagnetic signals from the sensitized region at unequal time periods $\Delta t_i$, the unequal time periods $\Delta t_i$ being determined so that the sampling occurs as the trajectory maps through equal areas of phase space $\Delta A_i$, and the unequal time periods $\Delta t_i$ being defined by

$$\Delta t_i = \Delta A / 2\pi c^2 t_i$$

wherein $\Delta A$ and $c$ are constants.

5. A method for nuclear magnetic resonance imaging comprising sensitizing a region of an object in a static magnetic field wherein the magnetization of the spins are transverse to the static field, spatially differentiating radiated electromagnetic energy from the sensitized region of the object, detecting the radiated electromagnetic energy from the sensitized region, and reconstructing spin information for each element within the region from the received radiated electromagnetic energy signals, characterised by the step of:

spatially differentiating the radiated electromagnetic energy by applying to the sensitized region a time varying magnetic field gradient which has a trajectory which maps through equal areas $\Delta A_i$ of phase space during equal time intervals, the magnetic field gradient having phases $f_1$ and $f_2$ defined by $f_1 = c\theta \cos\theta$ and $f_2 = c\theta \sin\theta$, and wherein the area $\Delta A_i$ over which the trajectory maps during equal time periods is given by

$$\Delta A_i = 2\pi c^2 \theta_i d\theta_i / dt \Delta t_i$$

wherein $\Delta A_i$ and $\Delta t_i$ are constant, and $\theta = (A+Bt)^{1/2}$, wherein A and B are constants.


**Patentanspruche**

1. Verfahren zur Bilderzeugung mittels magnetischer Kernresonanz, bei dem eine Region eines Objektes in einem statischen Magnetfeld sensitiviert wird, wobei die Magnetisierung der Spins quer zum statischen Feld verläuft, die sensitivierte Region des Objektes einem zeitlich veränderlichen Magnetfeldgradienten unterworfen wird, der ungleiche Flächenbereiche des Phasenraumes in gleichen Zeitintervallen abtastet, die von der sensitivierten Region abgestrahlte elektromagnetische Energie erfaßt wird und für jedes Element innerhalb dieser Region mittels der aus der abgestrahlten elektromagnetischen Energie empfangenen Signale Spininformationen rekonstruiert werden, gekennzeichnet durch den Schritt, daß

die aus der abgestrahlten elektromagnetischen Energie aufgenommenen Signale gewichtet werden, um eine Kompensation für die Anwendung zeitlich veränderlicher Magnetfeldgradienten zu erzielen, welche nicht gleiche Flächenbereiche des Phasenraumes in gleichen Zeitintervallen abtasten.

2. Verfahren nach Anspruch 1, bei welchem das Objekt eine zweidimensionale Scheibe ist und die Spininformationen nach der Gleichung

$$\rho(x,y) = \Sigma F(f_1,f_2) e^{-i(f_1 x + f_2 y)} e^{(t/T_2)} W(t) \Delta t^2$$

rekonstruiert werden, worin $F(f_1,f_2)$ die Fourier-Transformation der aus der abgestrahlten elektromagnetischen Energie empfangenen Signale ist, $f_1$ und $f_2$ die Phasenparameter in der x- bzw. y-Richtung sind, $f_1 = c_1 t$ und $f_2 = c_2 \sin t$, $T_2$ die Relaxationszeit in Querrichtung und W(t) die durch $W(t) = c_1 c_2 \cos t$ definierte Gewichtsfunktion ist, wobei $c_1$ und $c_2$ Konstante sind.

3. Verfahren nach Anspruch 1 oder 2, ferner gekennzeichnet durch den Schritt, daß

die abgestrahlte elektromagnetische Energie in veränderlichen Zeitintervallen abgetastet wird, wobei die veränderlichen Zeitintervalle zu der nicht linearen Trajektorie des Feldgradienten derart korreliert sind daß die abgestrahlte elektromagnetische Energie in gleichen Flächenelementen des Phasenraumes abgetastet wird.

4. Verfahren nach Anspruch 3, ferner gekennzeichnet durch die Schritte, daß

ein Magnetfeldgradient angewendet wird, der eine einer Archimedischen Spirale entsprechende Trajektorie gemäß der Gleichung $r = c\theta$ abbildet und bei dem der Gradient ungleiche Flächenbereiche $\Delta A$ während gleicher Zeitperioden $\Delta t$ abbildet, wobei die ungleichen Flächenbereiche definiert sind durch

$$\Delta A = 2\pi c^2 \theta i d\theta i / dt \Delta t,$$

worin c eine Konstante ist;

daß die von der sensitivierten Region abgestrahlten elektromagnetischen Signale in ungleichen Zeitperioden $\Delta t_i$ abgetastet werden, wobei die ungleichen Zeitperioden $\Delta t_i$ so festgelegt sind, daß die Abstastung jeweils erfolgt, wenn die Trajektorie über gleichen Flächenbereichen $\Delta A_i$ des Phasenraumes abtastet und die ungleiche Zeitperiode $\Delta t_i$ definiert sind durch

$$\Delta t_i = \Delta A / 2\pi c^2 ti,$$

worin $\Delta A$ und c Konstante sind.

EP 0 164 951 B1

5. Verfahren zur Bilderzeugung mittels magnetischer Kernresonanz, bei dem eine Region eines Objektes in einem statischen Magnetfeld sensitiviert wird, wobei die Magnetisierung der Spins quer zum statischen Feld verläuft, die von der sensitivierten Region des Objektes abgestrahlte elektromantische Energie räumlich differentziert wird, die von der sensitivierten Region abgestrahlte elektromagnetische Energie erfaßt wird und für jedes Element innerhalb dieser Region mittels der aus der abgestrahlten elektromagnetischen Energie empfangenen Signale Spininformationen rekonstruiert werden, gekennzeichnet durch den Schritt, daß

zur räumlichen Differenzierung der abgestrahlten elektromagnetischen Energie die sensitivierte Region einem zeitlich veränderlichen magnetischen Feldgradienten unterworfen wird, der eine Trajektorie aufweist, welche durch gleiche Flächenbereiche $\Delta A_i$ des Phasenraumes hindurch während gleicher Zeitintervalle abbildet, wobei der Magnetfeldgradient Phasen $f_1$ und $f_2$ hat, welche durch $f_1 = c\theta\cos\theta$ und $f_2 = c\theta\sin\theta$ definiert sind, und wobei der Flächenbereich $\Delta A_i$, über welchen die Trajektorie während gleicher Zeitperioden abbildet, gegeben ist durch

$$\Delta A_i = 2\pi c^2 \theta_i d\theta_i/dt\Delta_i,$$

worin $\Delta A_i$ und $\Delta t_i$ Konstante sind und $\theta = (A+Bt)^{1/2}$, wobei A und B Konstante sind.

**Revendications**

1. Un procédé d'imagerie par résonance magnétique nucléaire comprenant les opérations suivantes: on sensibilise une région d'un objet dans un champ magnétique statique, dans lequel l'aimantation des spins est transversale par rapport au champ statique, on applique à la région sensibilisée de l'objet un gradient de champ magnétique variant dans le temps qui échantillonne des aires inégales de l'espace de phase pendant des intervalles de temps égaux, on détecte l'énergie électromagnétique qui est rayonée à partir de la région sensibilisée, et on reconstruit une information de spin pour chaque élément à l'intérieur de la région, à partir des signaux d-énergie électromagnétique rayonnée qui sont reçus, caractérisé par l'opération suivante:

on pondère les signaux d'énergie électromagnétique rayonnée détectés, pour compenser l'utilisation de gradients de champ magnétique variant dans le temps qui n'échantillonnent pas des aires égales de l'espace de phase pendant des intervalles de temps égaux.

2. Un procédé selon la revendication 1, dans lequel la région de l'objet consiste en une tranche bidimensionnelle, et l'information de spin est reconstruite conformément à l'équation:

$$\rho(x,y) = \Sigma F(f_1,f_2)e^{-i(f_1 x + f_2 y)}e^{(t/T_2)}W(t)\Delta t^2$$

dans laquelle $F(f_1,f_2)$ est la transformée de Fourier des signaux d'énergie électromagnétique rayonnée qui sont détectés, $f_1$ et $f_2$ sont les paramètres de phase respectivement dans les directions x et y, $f_1 = c_1 t$ et $f_2 = c_2 \sin t$, $T_2$ est le temps de relaxation transversal et $W(t)$ est la fonction de pondération définie par $W(t) = c_1 c_2 \cos t$, $c_1$ et $c_2$ étant des constantes.

3. Un procédé selon la revendication 1 ou 2, caractérisé en outre par l'opération suivante:

on échantillonne l'énergie électromagnétique rayonnée à des intervalles de temps variables, les intervalles de temps variables étant corrélés à la trajectoire non linéaire du gradient de champ, de façon que l'énergie électromagnétique rayonnée soit échantillonnée dans des éléments d'aire égale de l'espace de phase.

4. Un procédé selon la revendication 3, caractérisé en outre par les opérations suivantes:

on utilise un gradient de champ magnétique qui définit une trajectoire en spirale d'Archimède conformément à l'équation $r = c\theta$, et dans lequel le gradient échantillonne des aires $\Delta A$ inégales pendant des intervalles de temps égaux $\Delta t$, les aires inégales étant définies par

$$\Delta A = 2\pi c^2 \theta_i d\theta_i/dt\Delta t$$

en désignant par c une constante; et

on échantillonne les signaux électromagnétiques rayonnés à partir de la région sensibilisée avec des intervalles de temps inégaux $\Delta t_i$, les intervalles de temps inégaux $\Delta t_i$ étant déterminés de façon que l'échantillonnage ait lieu pendant que la trajectoire passe par des aires égales de l'espace de phase $\Delta A_i$, et les intervalles de temps inégaux $\Delta t_i$ étant définis par

$$\Delta t_i = \Delta A/2\pi c^2 t_i$$

en désignant par $\Delta A$ et c des constantes.

5. Un procédé pour l'imagerie par résonance magnétique nucléaire, comprenant les opérations suivantes: on sensibilise une région d'un objet dans un champ magnétique statique dans lequel l'aimantation des spins est transversale par rapport au champ statique, on différencie dans l'espace l'énergie électromagnétique rayonnée provenant de la région sensibilisée de l'objet, on détecte l'énergie

6

électromagnétique rayonnée provenant de la région sensibilisée et on reconstruit une information de spin pour chaque élément à l'intérieur de la région, à partir des signaux d'énergie électromagnétique rayonnée qui sont reçus, caractérisé par l'opération suivante:

on différencie dans l'espace l'énergie électromagnétique rayonnée en appliquant à la région sensibilisée un gradient de champ magnétique variant dans le temps qui a une trajectoire qui passe par des aires égales $\Delta A_i$ de l'espace de phase pendant des intervalles de temps égaux, le gradient de champ magnétique ayant des phases $f_1$ et $f_2$ qui sont définies par $f_1 = c\theta\cos\theta$ et $f_2 = c\theta \sin \theta$, et dans lequel l'aire $\Delta A_i$ par laquelle la trajectoire passe pendant des intervalles de temps égaux est donnée par l'expression:

$$\Delta A_i = 2\pi c^2\theta_i d\theta_i/dt\Delta t_i$$

dans laquelle $\Delta A_i$ et $\Delta t_i$ sont des constantes, et $\theta = (A+Bt)^{1/2}$, en désigant par A et B des constantes.